(19)

Europäisches
Patentamt

European
Patent Office

Office européen
des brevets

(11)  **EP 3 068 040 A1**

(12)  # EUROPEAN PATENT APPLICATION

(43) Date of publication:
    **14.09.2016  Bulletin 2016/37**

(51) Int Cl.:
    *H02P 29/024* (2016.01)

(21) Application number: **16156041.2**

(22) Date of filing: **17.02.2016**

(84) Designated Contracting States:
    **AL AT BE BG CH CY CZ DE DK EE ES FI FR GB
    GR HR HU IE IS IT LI LT LU LV MC MK MT NL NO
    PL PT RO RS SE SI SK SM TR**
    Designated Extension States:
    **BA ME**
    Designated Validation States:
    **MA MD**

(30) Priority:  **09.03.2015  GB 201503930**

(71) Applicant: **Rolls-Royce plc
    London SW1E 6AT (GB)**

(72) Inventors:
    • **Athikessavan, Subash
    Derby, DE24 8BJ (GB)**

• **Nadarajan, Sivakumar
    Derby, DE24 8BJ (GB)**
• **Gupta, Amit
    Derby, DE24 8BJ (GB)**
• **Panda, Sanjib
    Derby, DE24 8BJ (GB)**
• **Gajanayake, Chandana
    Derby, DE24 8BJ (GB)**

(74) Representative: **Rolls-Royce plc
    Intellectual Property Dept SinA-48
    PO Box 31
    Derby DE24 8BJ (GB)**

(54)  **FAULT DETECTION AND DIAGNOSIS IN AN INDUCTION MOTOR**

(57)  A method of detecting rotor and/or stator side faults in an induction motor. Signals indicative of three-phase stator currents of the induction motor are acquired (10) and converted (16) into three-phase current phasors. The three-phase current phasors are combined (16) to obtain a quantity having a DC component and an AC component. A frequency spectrum of the AC component is obtained (18) and compared (20,22) to a frequency spectrum of the AC component under healthy operating conditions in order to determine the presence of a rotor and/or stator side fault in the induction motor

FIG. 1

**EP 3 068 040 A1**

**Description**

**BACKGROUND OF THE INVENTION**

This disclosure relates to induction motors, and in particular to methods of fault detection and diagnosis in an induction motor.

Conventional induction motors operate via a multi-phase stator ac winding and a rotor. When in use, an alternating current supplied to the stator winding causes a magnetic field to form. Due to the alternating nature of the current supplied to the stator winding, the magnetic field rotates in time with the oscillations of the current. Relative motion between the magnetic field and the induction motor's rotor induces a current in the rotor, which in turn creates a magnetic field that opposes the change in current through the rotor. The rotor thereby rotates in the same direction as the rotating magnetic field formed by the stator winding. The rotor and the magnetic field rotate at different speeds, and when the ratio between these speeds is high enough a torque is generated which may be used to turn a load.

Induction motors are extensively used in industry to drive a wide variety of machinery, and may also be used to form induction generators, which are useful for applications such as wind turbines. Examples of use of induction motors include use as actuators in aircraft, and use in propulsion motors in marine vessels. Reliable operation of induction motors is therefore vital.

Two of the most common reasons for the occurrence of faults in an induction motor are electrical and thermal stress. If electrical and thermal stress go undetected at an early stage, then they can lead to electrical (stator side) or mechanical (rotor side) failure, which may cause irreversible damage to the induction motor, and may result in increased maintenance costs. It is therefore desirable to avoid such failures, where possible.

Examples of prior systems for fault detection in electric machines are provided by US8135551, US5514978, US6640196 and EP2565658. Such systems generally require bespoke sensing of both three phase current and three phase voltage in order to adequately identify stator winding faults, for example to distinguish such faults from voltage unbalance. However the need for such a bespoke sensing arrangement adds cost and complexity to the machine.

Furthermore certain faults, such as air gap eccentricity faults, require current measurement at a particularly high sampling rate and/or a high resolution harmonic analysis. It has been found to be problematic to identify with certainty fault signatures that may be of particularly small magnitude at higher frequencies.

There has now been devised a method of detecting rotor and/or stator side faults in an induction motor, and a method of detecting and diagnosing rotor and/or stator side faults in an induction motor, which overcome or substantially mitigate the aforementioned and/or other disadvantages associated with the prior art.

**BRIEF SUMMARY OF THE DISCLOSURE**

According to a first aspect of the present disclosure there is provided a method of detecting rotor and/or stator side faults in an induction motor, the method comprising:

i. acquiring signals indicative of three-phase stator currents of the induction motor;
ii. converting the signals indicative of three-phase stator currents into three-phase current phasors;
iii. combining the three-phase current phasors to obtain a quantity having a DC component and an AC component;
iv. obtaining a frequency spectrum of the AC component; and
v. comparing the obtained frequency spectrum of the AC component to a frequency spectrum of the AC component under healthy operating conditions in order to determine the presence of a rotor and/or stator side fault in the induction motor.

The method of the first aspect of the present disclosure is advantageous as it may allow the detection of rotor and/or stator side faults in an induction motor using only the measured three-phase current. The need for additional sensors, for example voltage sensors, in order to detect rotor and/or stator side faults may be reduced or eliminated, thereby reducing the cost and complexity associated with fault detection in an induction motor.

Furthermore, the disclosure may be beneficial as the combination of the three-phase current phasors may increase the magnitude of the fundamental and harmonic frequencies of the AC component, and hence increase signal to noise ratio (SNR), thereby enabling for more reliable and earlier stage fault detection. In particular, in typical early stage fault detection the magnitudes of any harmonic components are relatively low, which makes it difficult to achieve reliable fault detection based on these harmonic components.

A method according to embodiments of the present disclosure may remove this difficulty by amplifying the magnitude of one or more relevant signal component, for example one or more harmonic component. This may be achieved via the combination of the three-phase current phasors. Such amplification may occur when the magnitude of the current is greater than 1 Amp (1 A), which may be particularly suited to industrial electrical machine applications.

The AC component may be substantially zero under healthy operating conditions, and may be substantially non-zero when a fault occurs in the induction motor.

The three-phase current phasors may be combined by calculating the square root of the squared sum of the three-phase current phasors. The combination of the three-phase current phasors in such a manner may be beneficial as it may combine the three-phase current phasors such that the magnitudes of any currents are amplified. This may result in an increased reliability of fault detection. In addition, any offset present in current/ voltage sensors will result in appearance of the fundamental frequency component in the AC component. If there is no offset a DC signal can be injected in all / any one of the three phase currents to induce the fundamental frequency component as that of three phase currents in the AC component.

A stator fault may be detected based on spectral features of the obtained frequency spectrum. A stator fault may be detected based on each of a fundamental supply frequency of the AC component or three-phase stator currents and at least one harmonic of the fundamental supply frequency of the AC component or three-phase stator currents. A stator fault may be detected based on a ratio of a magnitude of a fundamental supply frequency of the AC component or three-phase stator currents to a magnitude of a harmonic of the fundamental supply frequency of the AC component or three-phase stator currents. A stator fault may be detected based on a ratio of a magnitude of a harmonic of the fundamental supply frequency of the AC component or three-phase stator currents of the induction motor to a magnitude of a harmonic of the fundamental supply frequency of the AC component or three-phase stator currents of a healthy induction motor. A stator fault may or may not be detected based on a significant and/or sudden increase in said ratio. The harmonic in presently preferred embodiments may be the second harmonic of the fundamental supply frequency of the AC component or three-phase stator currents, or may be any harmonic of the fundamental supply frequency or three-phase stator currents of the AC component, for example up to the tenth harmonic.

A rotor fault may be detected based on spectral features of the obtained frequency spectrum. A rotor fault may be detected based on sideband components of at least one harmonic of a fundamental supply frequency of the AC component present in the obtained frequency spectrum. A rotor fault may be detected based on the presence of sideband components of at least one harmonic of a fundamental supply frequency of the AC component present in the obtained frequency spectrum. A rotor fault may be detected based on the magnitude of sideband components of at least one harmonic of a fundamental supply frequency of the AC component present in the obtained frequency spectrum. In presently preferred embodiments, the sideband components considered may be sidebands of the sixth harmonic of the fundamental supply frequency of the AC component.

The method may comprise determining whether the acquired signals indicative of three-phase stator currents of the induction motor are steady state signals, for example prior to combining the three-phase current phasors. This may be advantageous as it may eliminate and/or mitigate false fault detections based on fluctuations or transients present in the three-phase stator currents.

The signals indicative of three-phase stator currents may be filtered prior to conversion into three-phase current phasors and/or prior to determining whether the signals indicative of three-phase stator currents are steady state signals. The signals indicative of three-phase stator currents may be filtered using a digital low pass filter.

Determination of steady state signals may be based on frequency and magnitude variation analysis.

The frequency spectrum of the AC component may be obtained by a harmonic analysis, such as a Fourier transform/analysis. A discrete Fourier Transform (Fast Fourier transform) or other spectrum analysis techniques may be used.

The frequency spectrum of the AC component considered may be limited by a maximum frequency. The maximum frequency may be a harmonic of the fundamental supply frequency of the AC component. In presently preferred embodiments the frequency spectrum of the AC component may be considered up to the tenth harmonic of the fundamental supply frequency of the AC component.

The signals indicative of three-phase stator currents may be converted into three-phase current phasors by any conventional means, including, for example, using standard phasor transformations.

The method may comprise diagnosing the type of rotor and/or stator side fault.

Diagnosis of the type of stator side fault may be based on the magnitude of a fundamental supply frequency of the induction motor and the magnitude of at least one harmonic of the fundamental supply frequency of the induction motor, for each phase. Diagnosis of the type of stator fault may be based on a ratio of magnitude of a fundamental supply frequency of the induction motor to the square root of the sum of the magnitudes of harmonics of the fundamental supply frequency of the induction motor, for each phase.

Diagnosis of the type of stator fault may be based upon the variance between the ratios of the magnitude of the fundamental supply frequency of the induction motor to the square root of the sum of the magnitudes of harmonics of the fundamental supply frequency of the induction motor for each phase.

A stator fault may be diagnosed as a voltage unbalance fault when the variance of the ratio of the magnitude of the fundamental supply frequency to the square root of the sum of the magnitudes of harmonics of the fundamental supply frequency of the induction motor is less than the threshold value calculated from the healthy dataset of a corresponding working condition of the induction motor.

A stator fault may be diagnosed as a stator winding fault when the variance of the ratio of the magnitude of the fundamental supply frequency to the square root of the sum of the magnitudes of harmonics of the fundamental supply frequency of the induction motor is greater than the threshold value calculated from the healthy dataset of a corresponding working condition of the induction motor. The threshold value is the minimum value of the ratio of the magnitude of the fundamental supply frequency to the square root of the sum of the magnitudes of harmonics of the fundamental supply frequency of the healthy induction motor of each phase

In presently preferred embodiments, the harmonics of the fundamental supply frequency of the induction motor that may be considered are harmonics up to and including the seventh order harmonic.

Diagnosis of the type of rotor fault may be based on sideband components of harmonics of the fundamental supply frequency of the AC component. Diagnosis of the type of rotor fault may be based on the magnitude of sideband components of harmonics of the fundamental supply frequency of the AC component.

Diagnosis of the type of rotor fault may be based on the power distribution of sidebands around a selected harmonic.

A rotor fault may be diagnosed as a broken rotor bar fault when the power distribution is below a specified threshold value. For example under rated load condition the power distribution will be less than 1. A rotor fault may be diagnosed as an airgap eccentricity fault when the power distribution is above a specified threshold value. For example under rated load condition the power distribution will be greater than 1. The specified threshold value may vary between induction motors, and may be specified based on the healthy operating conditions of the induction motor.

Any of the preferential features of the first aspect of the present disclosure may equally be applied to any of the further aspects of the present disclosure, wherever practicable.

According to a second aspect of the present disclosure there is provided a method of detecting or diagnosing rotor and/or stator side faults in an induction motor, the method comprising:

    i. acquiring signals indicative of three-phase stator currents of the induction motor;
    ii. converting the signals indicative of three-phase stator currents into three-phase current phasors;
    iii. combining the three-phase current phasors to obtain a quantity having a DC component and an AC component;
    iv. obtaining a frequency spectrum of the AC component;
    v. converting each of the acquired signals indicative of three-phase stator currents of the induction motor into three-phase stator current frequency spectra; and
    vi. comparing the obtained three-phase stator current frequency spectra and/or the frequency spectrum of the AC component to spectra of the induction motor under healthy operating conditions in order to detect or diagnose the type of rotor and/or stator side fault.

The method according to the second aspect of the present disclosure may be advantageous in that it may allow rotor and/or stator side faults to be detected or diagnosed solely through the use of the measured three-phase current. Thus the need for additional sensors, for example voltage sensors, in order to detect and diagnose rotor and/or stator side faults may be eliminated, thereby reducing the cost and complexity associated with fault detection in an induction motor.

Furthermore, the method according to the second aspect of the present disclosure may provide the benefit of allowing for detection of healthy operating conditions at an early stage of the fault detection and diagnosis procedure. Thus healthy operation can be detected at an early stage, eliminating and/or mitigating the need for the entire fault detection and diagnosis procedure to be carried out in order to determine healthy operation. This may reduce the computational power required to determine healthy operation, and may decrease the time interval between successive iterations of the fault detection and diagnosis procedure during healthy operation, thereby resulting in an increased chance of detecting a fault at an early stage.

The signals indicative of three-phase stator currents of the induction motor may be converted into three-phase stator current frequency spectra using a Discrete Fourier Transform.

According to a third aspect of the present disclosure, there is provided a fault detector for an induction motor having one or more sensors thereon capable of acquiring signals indicative of three-phase stator currents of the induction motor, the detector comprising;

    i. a receiver for receiving signals indicative of three-phase stator currents of the induction motor;
    ii. a signal convertor for converting the signals indicative of three-phase stator currents into three-phase current phasors and combining the three-phase current phasors to obtain a quantity having a DC component and an AC component to obtain a frequency spectrum of the AC component; and
    iii. one or more processor arranged to compare the obtained frequency spectrum of the AC component to a frequency spectrum of the AC component under healthy operating conditions in order to determine the presence of a rotor and/or stator side fault in the induction motor.

According to a further aspect of the disclosure, there is provided a data carrier comprising machine readable instructions for the control of one or more processors of an induction motor fault detector to:

i. receive signals indicative of three-phase stator currents of the induction motor;
ii. convert the signals indicative of three-phase stator currents into three-phase current phasors;
iii. combine the three-phase current phasors to obtain a quantity having a DC component and an AC component;
iv. obtain a frequency spectrum of the AC component; and
v. compare the obtained frequency spectrum of the AC component to a frequency spectrum of the AC component under healthy operating conditions in order to determine the presence of a rotor and/or stator side fault in the induction motor.

The type of fault and the severity of the fault can be notified to the personnel. Depending on the severity of the fault the maintenance can be scheduled to avoid the catastrophic failure.

## BRIEF DESCRIPTION OF THE DRAWINGS

Preferred embodiments of the present disclosure will now be described in detail, by way of illustration only, with reference to the accompanying figures, of which:

Figure 1 is a flow diagram of a method of detecting rotor and/or stator side faults in an induction motor according to a first aspect of the present disclosure;

Figure 2 contains example frequency spectra of the AC component of $|ISP|^2$, for an induction motor operating at a slip of 0.035;

Figure 3 contains example frequency spectra of the AC component of $|ISP|^2$, for an induction motor operating at a slip of 0.035, around the sixth harmonic of the fundamental supply frequency;

Figure 4 contains example Discrete Fourier Transforms of the stator current for each phase in an induction motor operating, at a slip of 0.035, with a stator winding fault, and the ITHD values associated therewith;

Figure 5 contains example Discrete Fourier Transforms of the stator current for each phase in an induction motor operating, at a slip of 0.035, with a voltage unbalance fault, and the ITHD values associated therewith;

Figure 6 is a flow diagram of a method of detecting and diagnosing rotor and/or stator side faults in an induction motor according to a second aspect of the present disclosure;

Figure 7 is a flow diagram of an alternative method of detecting and diagnosing rotor and/or stator side faults in an induction motor to the method of Figure 6; and

Figure 8 is a flow diagram of an alternative method of detecting and diagnosing rotor and/or stator side faults in an induction motor to the methods of Figures 6 and 7.

## DETAILED DESCRIPTION OF THE INVENTION

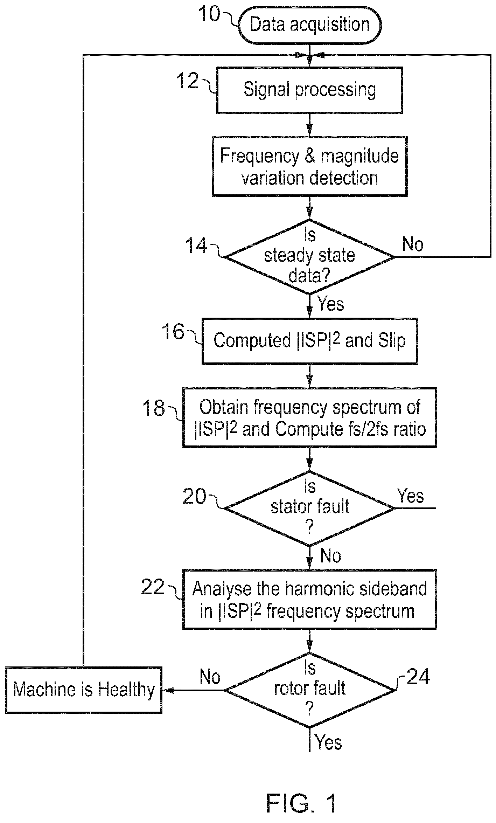

A method of detecting rotor and/or stator faults in an induction motor according to a first aspect of the present disclosure is described with reference to Figure 1.

The method makes use of the Instantaneous Space Phase Square ($|ISP|^2$) of the stator current. The $|ISP|^2$ of stator current is calculated by converting the stator phase currents into phasors and then obtaining the square root for the squared sum of the three phase current phasors. The procedure for obtaining the $|ISP|^2$ is given below, and utilises the stator phase currents $P_1$, $P_2$, and $P_3$, for phases a, b, and c, respectively.

$$P_1 = I_a \sin(\omega t - \Phi_1)^*(\cos(0) + j\sin(0)) \qquad (1)$$

$$P_2 = I_b\sin(\omega t - \Phi_2)*(\cos(2\pi/3) + j\sin(2\pi/3)) \qquad (2)$$

$$P_3 = I_c\sin(\omega t - \Phi_3)*(\cos(-2\pi/3) + j\sin(-2\pi/3)) \qquad (3)$$

$$|ISP|^2 = (\sqrt{(real(P_1 + P_2 + P_3)^2 + img(P_1 + P_2 + P_3)^2)})^2 \qquad (4)$$

The $|ISP|^2$ has both DC and AC components, which are given by the following equations respectively:

$$DC = 1/2\,[I_a^2 + I_b^2 + I_c^2] - 1/2\,[I_aI_b\cos(\Phi_2 - \Phi_1) + I_aI_c\cos(\Phi_3 - \Phi_1) + I_bI_c\cos(\Phi_2 - \Phi_3) \qquad (5)$$

$$AC = -1/2[I_a^2\cos(2\omega t - 2\Phi_1) + I_b^2\cos(2\omega t - 2\Phi_2) + I_c^2\cos(2\omega t - 2\Phi_3)]$$

$$-1/2\,[I_aI_b\cos(2\omega t - (\Phi_1 + \Phi_1)) + I_aI_c\cos(2\omega t - (\Phi_1 + \Phi_3)) + I_bI_c\cos(2\omega t - (\Phi_2 + \Phi_3))] \qquad (6)$$

Under healthy operation conditions, each of the three phase currents are equal in magnitude, with phase shifts of 0°, -120°, and -240°, for phases a, b, and c, respectively. Thus under healthy operation conditions, $I_a = I_b = I_c = I$, and $\Phi_1 = 0°$, $\Phi_2 = -120°$, and $\Phi_3 = -240°$. The DC and AC components of the $|ISP|^2$ under healthy operation conditions are thus given by:

$$DC = 1.5*I \qquad (7)$$

$$AC = 0 \qquad (8)$$

In general, even under healthy operation conditions of the motor, there will be a small (0.1 to 1 % of fundamental component of maximum phase current) AC component because of small unbalances in the stator current due to inherent asymmetries introduced during machine manufacturing. However the magnitude of this AC component will be much less than any AC component introduced due to faults or supply voltage unbalance in the machine.

When there is a stator fault condition, or there is an unbalanced power supply, the magnitude of the AC component of the $|ISP|^2$, and its harmonic components, will vary significantly (greater than 1 % of fundamental component of maximum phase current) from the zero value of healthy operating conditions. This variation is dependent both on the type of the fault, and its severity, and thus allows a fault to be both detected and diagnosed.

Asymmetry in the three phase stator current magnitude/phase angle increases the magnitude of the spectral component of the $|ISP|^2$ AC component at twice the fundamental supply frequency of the $|ISP|^2$ AC component. Hence the ratio of $f_s$ to $2f_s$ is used to detect stator anomalies, where $f_s$ is the fundamental supply frequency of the AC component. The magnitude of the $2f_s$ component in the AC component of the $|ISP|^2$ of stator current occurs primarily because of unequal current magnitudes between the phases, which reduce the ratio under stator side fault compared to that under healthy operating conditions. In order to detect stator faults, the threshold value for the ratio of $f_s$ to $2f_s$ is set based on the ratio under healthy operation. The threshold value will be usually 1 for a healthy induction machine. If a stator fault is detected, then a fault indicator is set.

If there are any rotor side anomalies present in the motor, then the ratio of $f_s$ to $2f_s$ is largely unchanged from the ratio under healthy operating conditions. Thus, in order to detect rotor side anomalies, frequency sidebands around the $6f_s$ AC component of the $|ISP|^2$ are analysed, and compared to a threshold value that is set based on healthy operating conditions of the motor. The threshold value is typically 10% of the magnitude of the 6fs AC component of the $|ISP|^2$ If there are sidebands with a magnitude that is greater than the threshold value, then a rotor side fault is present, and a fault indicator is set.

The method of the first aspect of the present disclosure initially involves the step of acquiring values 10 for the three phase current signal, and the speed of the motor, using a data acquisition system. The maximum frequency for fault signature detection and analysis is set as 10 times the fundamental frequency of stator current signal. Hence, the current signals are sampled at a frequency of 10 times the fundamental frequency of the phase current. Increasing the sampling frequency will increase the computational time. At specified periods of time, typically $n$ seconds (ranges from 1 s to few seconds) the data is acquired, and then stored in a buffer to convert the samples into a vector to obtain the frequency spectrum using a Discrete Fourier Transform (DFT) The value of n depends on the required frequency resolution and the value should be greater than 5 for fault signature detection at low loads. From the acquired data, any one of the phase currents is selected, and is smoothed using a digital low pass filter 12. The smoothed current is then used to detect transients in the machine by analysing the variation in the frequency and magnitude, so as to confirm that the acquired signals are a steady state signal 14. If any transient is detected, then the fault detection and diagnosis process is bypassed and the data is acquired once again. If there is no transient, then the signal enters the first stage of fault detection and diagnosis (FDD).

The first stage of FDD involves the computation of the $|ISP|^2$ value 16, as previously discussed. The slip of the induction motor is also calculated using conventional methods. The frequency spectrum of the AC component of the $|ISP|^2$ is obtained, and the ratio of $f_s$ to $2f_s$ is calculated 18. This allows any stator side faults to be detected and diagnosed by comparison with the ratio under healthy operating conditions 20. If no stator side faults are present, then the harmonic sidebands around the $6f_s$ component of the AC component of the $|ISP|^2$ spectrum are analysed 22, and compared to threshold values based on healthy operating conditions of the induction motor. If a rotor side fault is found, then a fault indicator is set 24.

If there are no stator or rotor anomalies found, then the machine is diagnosed as healthy, and the process is repeated using newly acquired data.

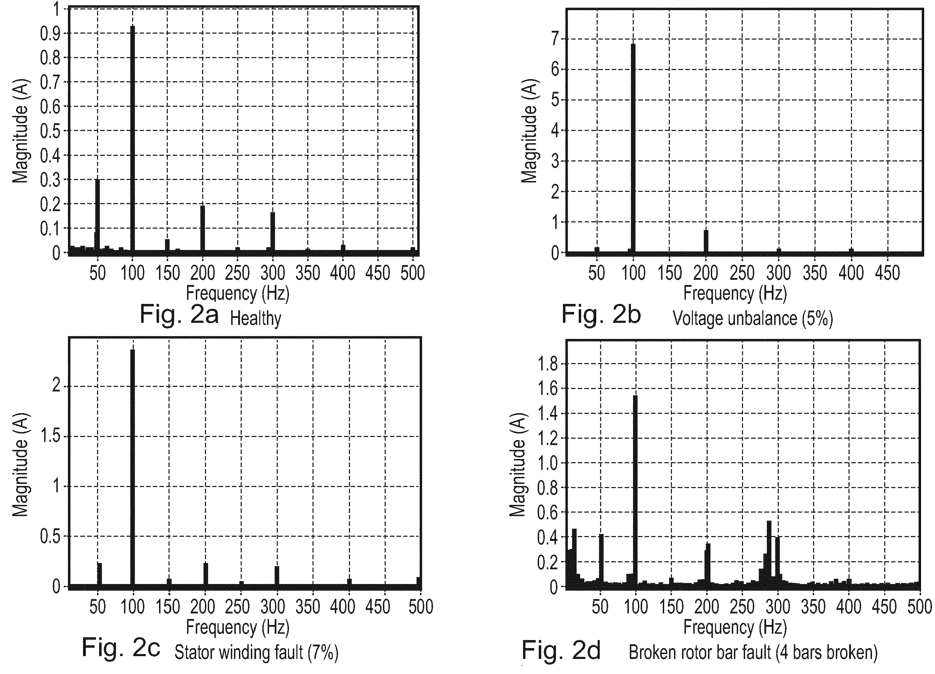

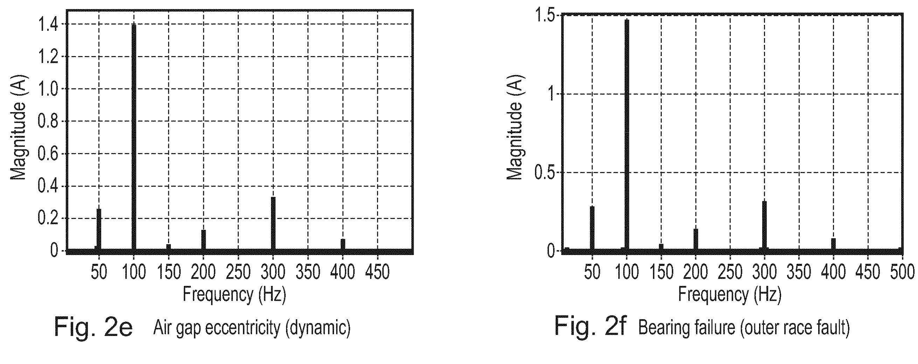

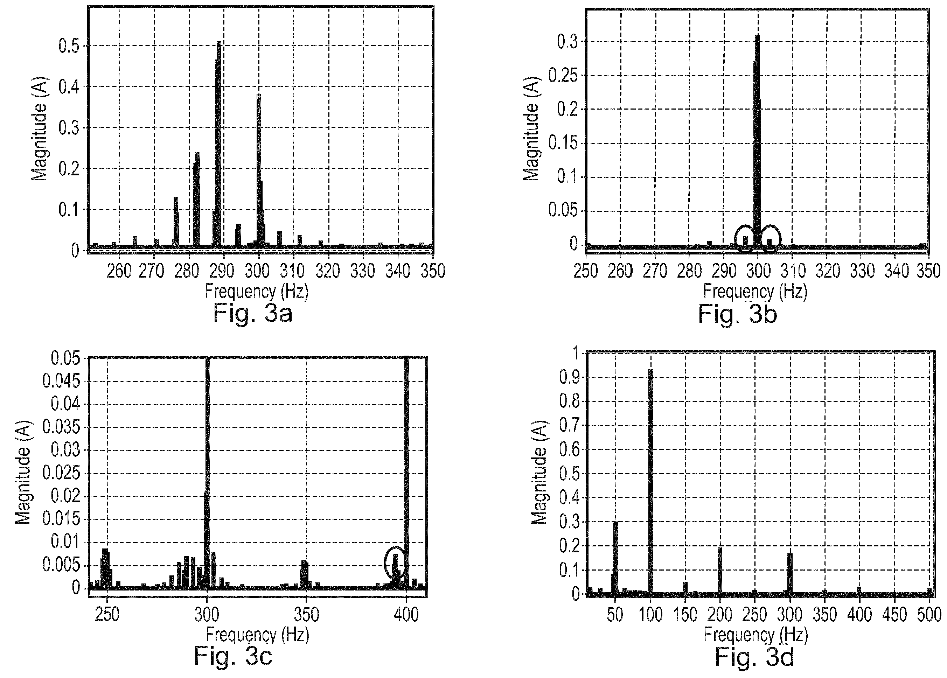

Examples of frequency spectra of the AC component of the $|ISP|^2$ are shown in Figures 2 and 3.

Figure 2(a) is an example frequency spectrum of the AC component of the $|ISP|^2$ of an induction motor, operating at a slip of 0.035, which has a fundamental frequency, $f_s$, of 50 Hz. Figures 2(b) and 2(c) are examples of the frequency spectrum of Figure 2(a) when a voltage unbalance fault and a stator winding fault occur, respectively. As can be seen from a comparison between Figures 2(a), 2(b), and 2(c), the presence of a stator side fault (i.e. a voltage unbalance fault or a stator winding fault) causes a significant increase in the magnitude of the ratio between $f_s$ and $2f_s$, and thus this ratio may be used to detect stator side faults.

Figures 2(d), 2(e), and 2(f), are examples of the frequency spectrum of Figure 2(a) when a broken rotor bar fault, an air gap eccentricity fault, and a bearing failure fault, occur respectively. As can be seen from a comparison between Figures 2(a), 2(d), 2(e), and 2(f), the ratio of $f_s$ to $2f_s$ is largely unchanged between the figures, and thus this ratio is not used to detect rotor side faults (ie broken rotor bar faults, air gap eccentricity faults, or bearing failure faults).

Figure 3(d) is an example frequency spectrum of the AC component of the $|ISP|^2$ of an induction motor, operating at a slip of 0.035, around the sixth harmonic, $6f_s$, of the fundamental frequency, $f_s$, of 50 Hz. As can be seen from Figure 3(d), there are no sidebands around the $6f_s$ component during healthy operation. Figures 3(a), 3(b), and 3(c), are examples of the frequency spectrum of Figure 3(d) when there is a broken rotor bar fault, an air gap eccentricity fault, and a bearing failure fault, respectively. As can be seen from a comparison between Figures 3(a), 3(b), 3(c), and 3(d), sidebands occur around the $6f_s$ component when a rotor side fault (ie a broken rotor bar fault, an air gap eccentricity fault, or a bearing failure fault) occurs, and thus an analysis of the sideband components around $6f_s$ of the AC component of the $|ISP|^2$ can be used to detect rotor side faults. It will further be observed that sideband components occur around $8f_s$ in the case of a bearing failure fault, which is the bearing fault specific frequency signature.

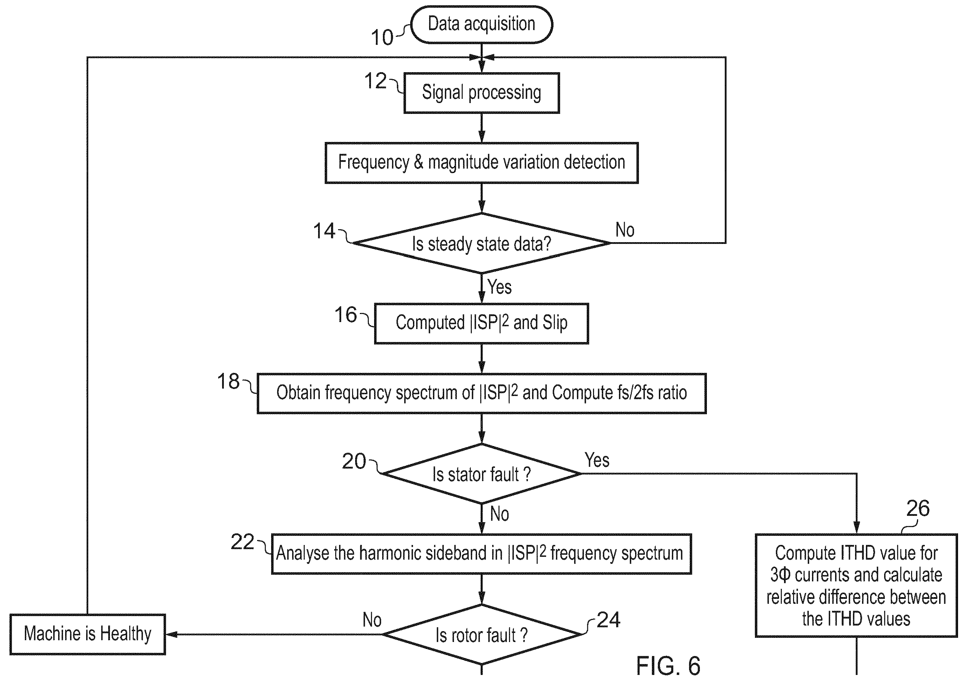

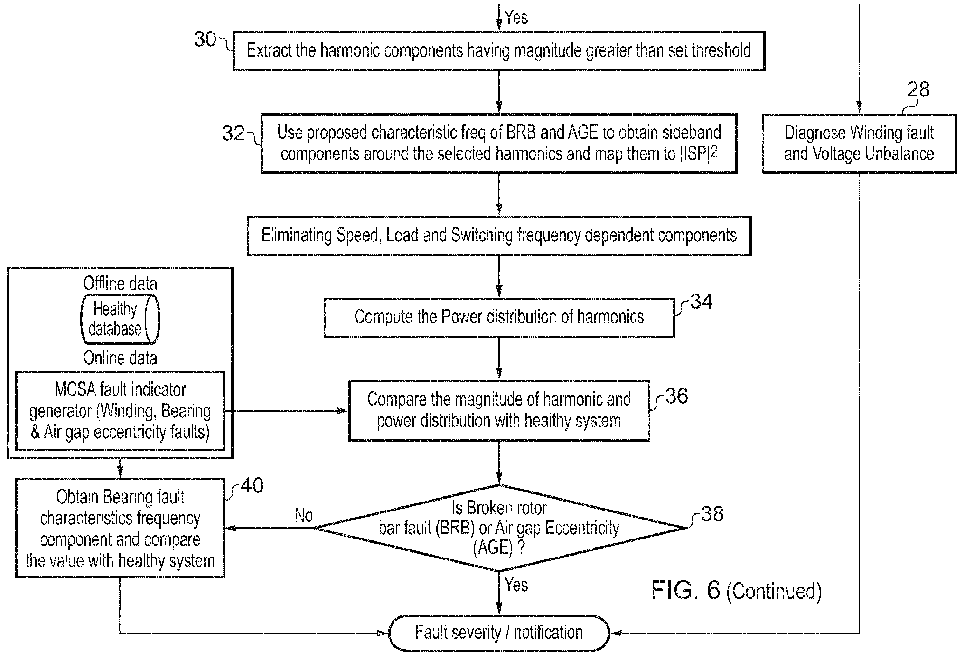

A method of detecting and diagnosing rotor and/or stator faults in an induction motor according to a second aspect of the present disclosure is described with reference to Figure 6.

In brief, the method according to the second aspect of the present disclosure utilises the method of the first aspect of the present disclosure to detect whether a stator or rotor side fault is present in the induction motor, and then utilises various techniques to diagnose the type of fault that is present. These techniques are discussed in more detail below.

To diagnose the type of stator side fault that is present, the Inverse Total Harmonic Distortion (ITHD) is calculated, as will now be discussed.

Firstly, the three phase currents of the motor are measured using current sensors and are then converted using a Discrete Fourier Transform to determine the relevant frequencies. A threshold based peak detection algorithm is used to detect any harmonic peaks which are greater than 1 % of the magnitude of the fundamental frequency. The threshold 1% is heuristic, the percentage value can be fixed and it can be varied until harmonics are detected (typically it should be greater than 0.5%). The detected harmonic magnitudes are used to calculate the ITHD value for all three phases using the equation below;

$$\text{ITHD} = \frac{I_{f1}}{\sqrt{\sum_{n=2}^{\infty} I_{fn}}} \qquad (9),$$

where $I_{f1}$ is the magnitude of the fundamental frequency, and $I_{fn}$ is the magnitude of the nth harmonic.

In order to diagnose the type of stator side fault present, the ITHD values are computed for each phase, namely phases a, b, and c, and the variance of the ITHD values of the phases are calculated. In presently preferred embodiments, the ITHD values are computed by considering harmonic components up to the seventh order. Where the variance is less than 150% of the minimum ITHD value of all phases of a healthy induction motor, the fault is characterised as a voltage unbalance fault. Furthermore, if the variance is greater than 150% of the minimum ITHD value of all phases of a healthy induction motor, the fault is characterised as a stator winding fault. This occurs as a stator winding fault in one phase causes the stator current of that phase to decease, whilst causing the stator currents of the remaining two phases to increase. Furthermore, it is observed that the variance of the ITHD values increases with the severity of the fault for stator winding faults.

Hence the type of stator side fault present in an induction motor can be characterised.

Examples of the ITHD values of an induction motor operating under healthy and faulty conditions are shown in Table 1 below.

| | Stator winding fault | | | Voltage unbalance fault | | | Healthy | | |
|---|---|---|---|---|---|---|---|---|---|
| **Phase** | Phase 1 | Phase 2 | Phase 3 | Phase 1 | Phase 2 | Phase 3 | Phase 1 | Phase 2 | Phase 3 |
| **ITHD** | 15.71 | 11.87 | 22.62 | 12.32 | 9.94 | 16.0 | 20.19 | 19.58 | 22.86 |
| **Variance** | 29.68 | | | 9.32 | | | 3.04 | | |
| | Broken rotor bar fault | | | Air gap eccentricity | | | Bearing failure | | |
| **Phase** | Phase 1 | Phase 2 | Phase 3 | Phase 1 | Phase 2 | Phase 3 | Phase 1 | Phase 2 | Phase 3 |
| **ITHD** | 20.88 | 21.49 | 27.68 | 20 | 19.58 | 23 | 19.97 | 19.43 | 23.30 |

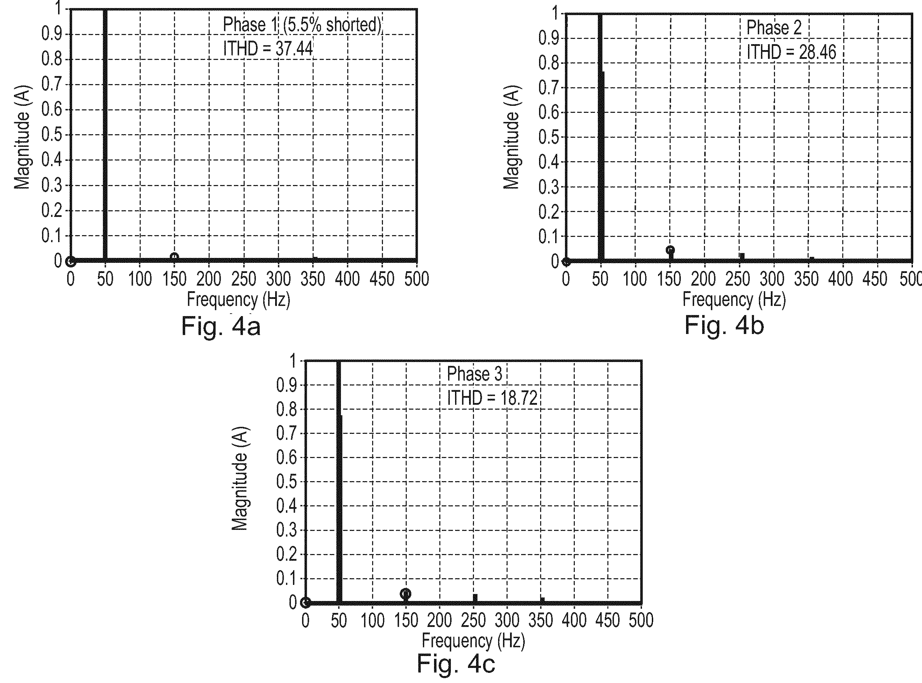

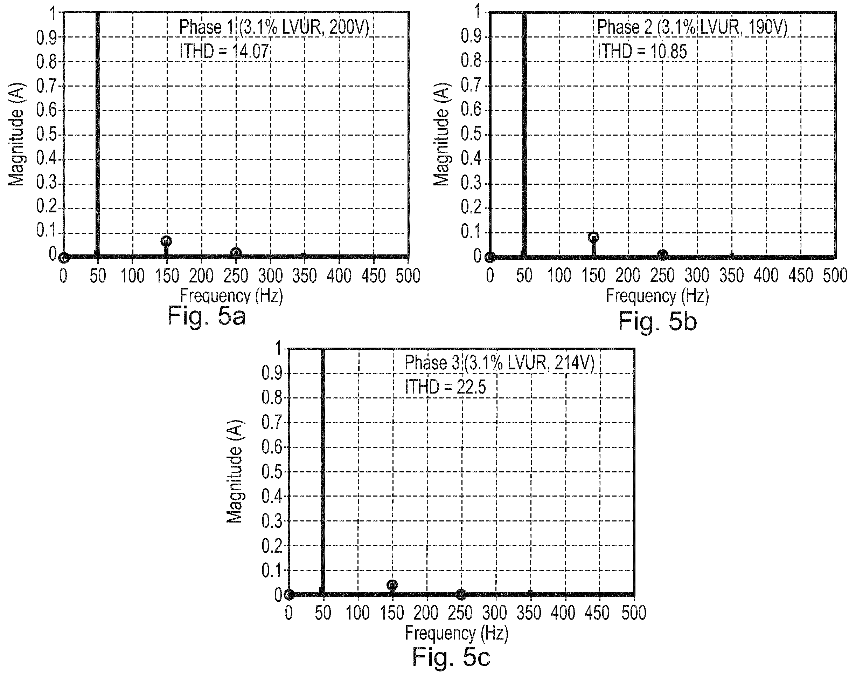

Examples of the Discrete Fourier Transforms of the three-phase currents for an induction motor operating at a slip of 0.035, having a stator winding fault and a voltage unbalance fault are shown in Figures 4 and 5 respectively.

To diagnose the type of rotor side fault that is present, the New Characteristic Equation (NCE) is used, in combination with a comparison between the power distributions of harmonics. The NCE is disclosed in pending UK patent application, GB1404226.1 which is hereby incorporated by reference.

In particular, the NCE is given by:

$$f_{brb} = ((1-s)f_h \pm ksf_s) \qquad (10),$$

where k=1, 2, 3... is the nth order harmonic, $f_s$ is the fundamental frequency, and $f_h=f_s$, $2f_s$, $3f_s$, etc.

In order to utilise the values obtained by the NCE, the frequency spectrum is mapped to the $|ISP|^2$ spectrum using the following FFT:

**FFT of Stator Current**     **FFT of $|ISP|^2$**

$f_n$                          $nf_1 - f_1$, $nf_1 + f_1$. $2nf_1$

The power distributions of the sidebands around a selected harmonic are given by:

$$Power\ distribution = \frac{\mathrm{mag(selected\ harmonic)}}{\sqrt{\sum_{n=real\ number}^{\infty} mag((selected\ harmonic)*(fs \pm n*fs))^2}} \qquad (11)$$

Where the power distribution is low (<1), the fault is a broken rotor bar fault, and the power distribution is characterized by sidebands of significant magnitudes, as well as having more than two sidebands. Eccentricity faults are characterised by higher power distribution (>1) as the sidebands magnitude are low (less than 20% of the harmonic magnitude), and lower numbers of sidebands, than those present when the fault is a broken rotor bar fault.

Where neither a broken rotor bar fault, nor an air gap eccentricity fault, are diagnosed, conventional bearing fault frequency equations are utilised to diagnose a bearing fault. The conventional bearing fault frequency equations are shown below:

$$f_{bf}=|f_0 \pm m f_v| \qquad (12)$$

where $f_{bf}$ is the bearing failure frequency, $f_o$ is the supply frequency, m is a positive integer, and $f_v$ is one of the characteristic vibration frequencies due to bearing fault which are given by

$$f_{race}=(n/2)f_r(1+(b_d/p_d)\cos\beta) \qquad (13)$$

$$f_{ball}=(b_d/(2p_d))f_r(1-((b_d/p_d)\cos\beta)^2) \qquad (14)$$

where, n is the number of bearing balls, the broken rotor bar frequency $f_r$ is the mechanical rotor speed in Hz, $b_d$ is the ball diameter, $p_d$ is the bearing pitch diameter, and $\beta$ is the contact angle of the balls on the races. The data obtained from these equations is compared to data of the machine operating under healthy conditions, in order to diagnose a bearing fault.

The method of the second aspect of the present disclosure utilises the method of the first aspect of the present disclosure to detect if a stator or rotor side fault is present.

Where a stator side fault has been detected, ITHD values are computed for the three phase current, and the variance of the ITHD values for the three phase current are measured 26, as discussed previously. The stator side fault is either characterised as a stator winding fault, or a supply voltage unbalance fault 28, and is notified to a user.

Where a rotor side fault has been detected, harmonic components having a value greater than a threshold value, typically 1% of the magnitude of the fundamental, are identified using a peak detection algorithm 30. The NCE is used to obtain sideband components around selected harmonics, and then a DFT is used to map the frequencies to the $|ISP|^2$ spectrum 32. Relevant sideband components are considered, and the power distribution is calculated 34 and compared to that of the induction motor under healthy operating conditions 36.

Where the power distribution is low, the fault is a broken rotor bar fault, and the power distribution is characterized by sidebands of significant magnitudes, as well as having more than two sidebands in total. Eccentricity faults are characterised by sidebands of an even lower magnitude, and lower numbers of sidebands, than those present when the fault is a broken rotor bar fault. Where either a broken rotor bar fault, or an air gap eccentricity fault, is diagnosed, a user is notified 38.

Where neither a broken rotor bar fault, nor an air gap eccentricity fault, is diagnosed, conventional methods are used to diagnose a bearing fault 40, as previously discussed.

Thus the method according to the second aspect of the present disclosure allows for the detection and diagnosis of both stator side faults and rotor side faults in an induction motor.

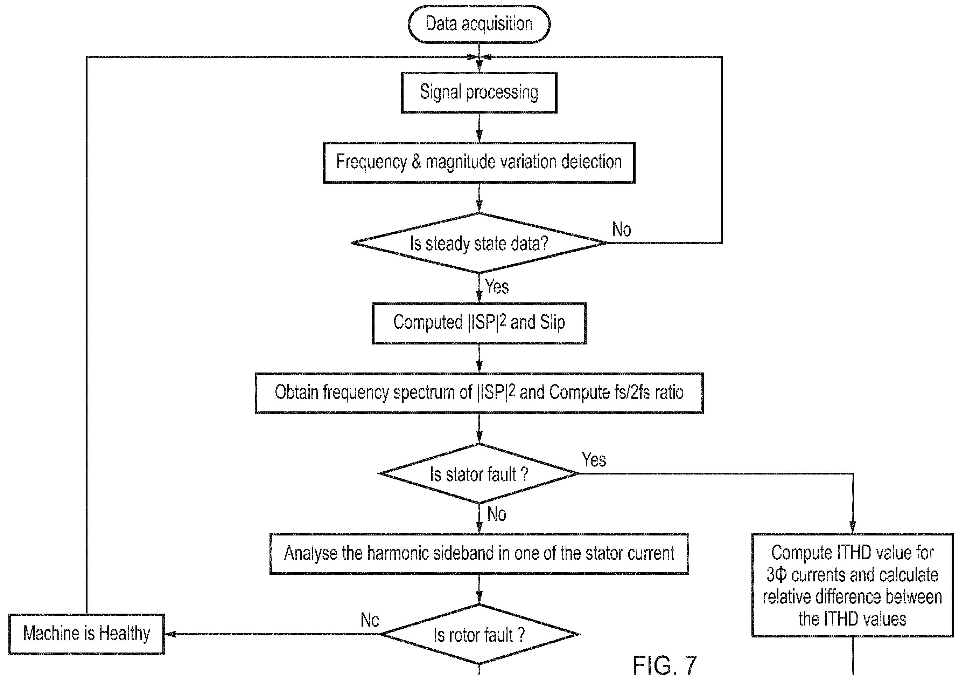

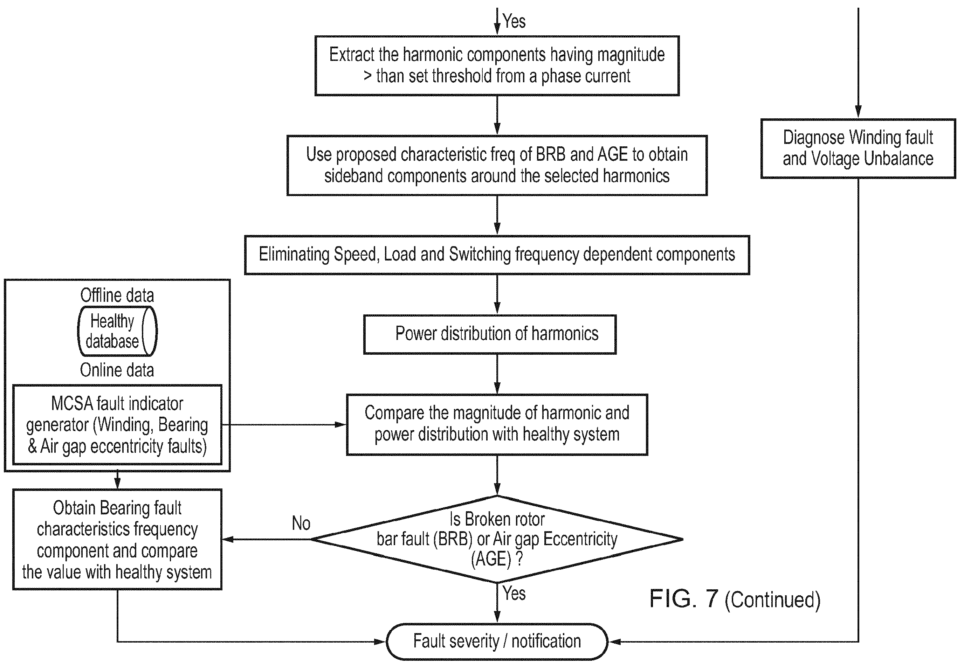

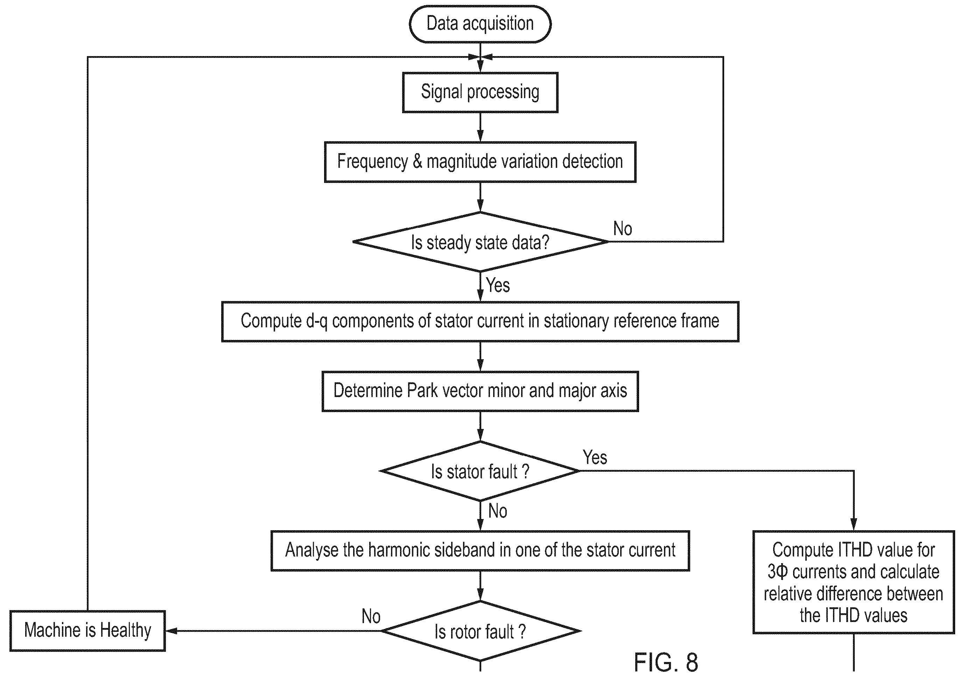

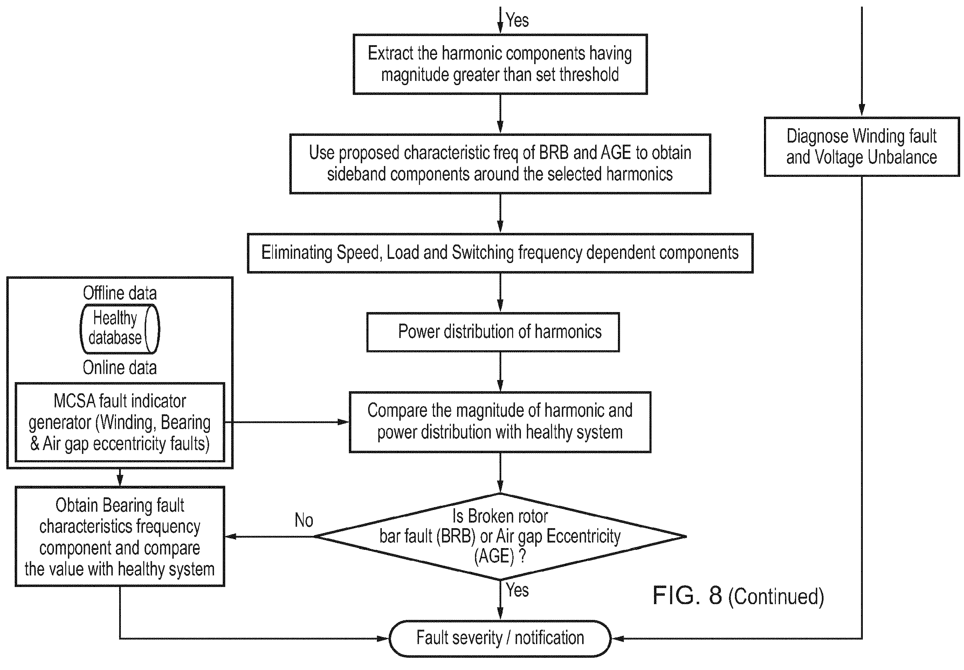

Alternative methods of detecting and diagnosing rotor and/or stator faults in an induction motor are shown in flow diagram form in Figures 7 and 8.

The method of Figure 7 is largely the same as the method of Figure 6, and differs only in the detection and diagnosis of rotor side faults. In particular, the method of Figure 7 detects and diagnoses rotor side faults by analysing fault signatures present in the three-phase current waveforms, as opposed to analysing the frequency spectrum of the AC component of the $|ISP|^2$, as is done in relation to the method of Figure 6.

The method of Figure 8 is largely the same as the method of Figure 7, and differs only in the detection of stator side faults. In particular, the method of Figure 8 detects stator side faults by computing the d-q components, via a direct-quadrature-zero (dqo) transformation, of the stator current in a stationary reference frame, and by determining the Park vector minor and major axes, as opposed to computing $|ISP|^2$, obtaining the frequency spectrum of the AC component of $|ISP|^2$, and comparing the ratio of $f_s$ to $2f_s$, as is done in relation to the method of Figure 7.

## Claims

1. A method of detecting rotor and/or stator side faults in an induction motor, the method comprising:

> i. acquiring signals indicative of three-phase stator currents of the induction motor;
> ii. converting the signals indicative of three-phase stator currents into three-phase current phasors;
> iii. combining the three-phase current phasors to obtain a quantity having a DC component and an AC component;
> iv. obtaining a frequency spectrum of the AC component; and
> v. comparing the obtained frequency spectrum of the AC component to a frequency spectrum of the AC component under healthy operating conditions in order to determine the presence of a rotor and/or stator side fault in the induction motor.

2. The method as claimed in Claim 1 wherein the three-phase current phasors are combined by calculating the square root of the squared sum of the three-phase current phasors.

3. The method as claimed in any preceding claim, wherein a stator fault is detected based on a ratio of a fundamental supply frequency of the AC component to a harmonic of the fundamental supply frequency of the AC component.

4. The method as claimed in any preceding claim, wherein a rotor fault is detected based on sideband components of at least one harmonic of the fundamental supply frequency of the AC component that are present in the obtained frequency spectrum.

5. The method as claimed in any preceding claim comprising determining whether the acquired signals indicative of three-phase stator currents of the induction motor are steady state signals, prior to combining the three-phase current phasors.

6. The method as claimed in any preceding claim, comprising diagnosing the type of rotor and/or stator side fault.

7. The method as claimed in Claim 6, wherein diagnosis of the type of stator fault is based on the magnitude of a fundamental supply frequency of the induction motor, and the magnitude of at least one harmonic of the fundamental supply frequency of the induction motor, for each phase.

8. The method as claimed in Claims 6 or 7, wherein diagnosis of the type of stator fault is based on a ratio of the magnitude of a fundamental supply frequency of the induction motor to the square root of the sum of the magnitudes of harmonics of the fundamental supply frequency of the induction motor, for each phase.

9. The method as claimed in Claim 8, wherein diagnosis of the type of stator fault is based upon the variance of the ratios of the magnitude of the fundamental supply frequency of the induction motor to the square root of the sum of the magnitudes of harmonics of the fundamental supply frequency of the induction motor of each phase.

10. The method as claimed in Claim 9, wherein the stator fault is diagnosed as a voltage unbalance fault when the variance is less than 150% of the minimum ITHD value of all phases of a healthy induction motor and/or the stator fault is diagnosed as a stator winding fault when the variance is greater than 150% of the minimum ITHD value of all phases of a healthy induction motor

11. The method as claimed in Claim 6, wherein diagnosis of the type of rotor fault is based on sideband components of harmonics of the fundamental supply frequency of the AC component.

12. The method as claimed in Claim 11, wherein the rotor fault is diagnosed as a broken rotor bar fault when the power distribution of sidebands around a selected harmonic is below a specified threshold value and/or the rotor fault is diagnosed as an airgap eccentricity fault when the power distribution of sidebands around a selected harmonic is above a specified threshold value.

13. The method as claimed in any preceding claim, the method comprising:

    i. converting each of the acquired signals indicative of three-phase stator currents of the induction motor into three-phase stator current frequency spectra; and
    ii. comparing the obtained three-phase stator current frequency spectra and/or the frequency spectrum of the AC component to spectra of the induction motor under healthy operating conditions in order to diagnose the type of rotor and/or stator side fault.

14. A fault detector for an induction motor having one or more sensors thereon capable of acquiring signals indicative of three-phase stator currents of the induction motor, the detector comprising;

    i. a receiver for receiving signals indicative of three-phase stator currents of the induction motor;
    ii. a signal convertor for converting the signals indicative of three-phase stator currents into three-phase current phasors and combining the three-phase current phasors to obtain a quantity having a DC component and an AC component to obtain a frequency spectrum of the AC component; and

iii. one or more processor arranged to compare the obtained frequency spectrum of the AC component to a frequency spectrum of the AC component under healthy operating conditions in order to determine the presence of a rotor and/or stator side fault in the induction motor.

15. A data carrier comprising machine readable instructions for the control of one or more processors of an induction motor fault detector to:

i. receive signals indicative of three-phase stator currents of the induction motor;
ii. convert the signals indicative of three-phase stator currents into three-phase current phasors;
iii. combine the three-phase current phasors to obtain a quantity having a DC component and an AC component;
iv. obtain a frequency spectrum of the AC component; and
v. compare the obtained frequency spectrum of the AC component to a frequency spectrum of the AC component under healthy operating conditions in order to determine the presence of a rotor and/or stator side fault in the induction motor.

10 ⟶ ( Data acquisition )

12 ⟶ Signal processing

Frequency & magnitude
variation detection

14 ⟶ Is
steady state
data? ──No

Yes

16 ⟶ Computed |ISP|2 and Slip

18 ⟶ Obtain frequency spectrum of
|ISP|2 and Compute fs/2fs ratio

20 ⟶ Is
stator fault
? ──Yes

No

22 ⟶ Analyse the harmonic sideband
in |ISP|2 frequency spectrum

Machine is Healthy ◄──No── Is
rotor fault
? ⟶ 24

Yes

FIG. 1

Fig. 2a  Healthy

Fig. 2b  Voltage unbalance (5%)

Fig. 2c  Stator winding fault (7%)

Fig. 2d  Broken rotor bar fault (4 bars broken)

Fig. 2e   Air gap eccentricity (dynamic)

Fig. 2f   Bearing failure (outer race fault)

Fig. 3a

Fig. 3b

Fig. 3c

Fig. 3d

Fig. 4a

Fig. 4b

Fig. 4c

Phase 2 (3.1% LVUR, 190V)
ITHD = 10.85

Magnitude (A)

Frequency (Hz)

**Fig. 5b**

Phase 3 (3.1% LVUR, 214V)
ITHD = 22.5

Magnitude (A)

Frequency (Hz)

**Fig. 5c**

Phase 1 (3.1% LVUR, 200V)
ITHD = 14.07

Magnitude (A)

Frequency (Hz)

**Fig. 5a**

FIG. 6

28 — Diagnose Winding fault and Voltage Unbalance

↓Yes

30 — Extract the harmonic components having magnitude greater than set threshold

32 — Use proposed characteristic freq of BRB and AGE to obtain sideband components around the selected harmonics and map them to $||ISP|^2$

Eliminating Speed, Load and Switching frequency dependent components

34 — Compute the Power distribution of harmonics

36 — Compare the magnitude of harmonic and power distribution with healthy system

38 — Is Broken rotor bar fault (BRB) or Air gap Eccentricity (AGE) ?

Yes →

No ↓

Offline data

Healthy database

Online data

MCSA fault indicator generator (Winding, Bearing & Air gap eccentricity faults)

40 — Obtain Bearing fault characteristics frequency component and compare the value with healthy system

Fault severity / notification

FIG. 6 (Continued)

FIG. 7

FIG. 7 (Continued)

FIG. 8

Diagnose Winding fault and Voltage Unbalance

Yes

Extract the harmonic components having magnitude greater than set threshold

Use proposed characteristic freq of BRB and AGE to obtain sideband components around the selected harmonics

Eliminating Speed, Load and Switching frequency dependent components

Power distribution of harmonics

Compare the magnitude of harmonic and power distribution with healthy system

Is Broken rotor bar fault (BRB) or Air gap Eccentricity (AGE) ?

No

Yes

Fault severity / notification

Offline data

Healthy database

Online data

MCSA fault indicator generator (Winding, Bearing & Air gap eccentricity faults)

Obtain Bearing fault characteristics frequency component and compare the value with healthy system

FIG. 8 (Continued)

Europäisches
Patentamt
European
Patent Office
Office européen
des brevets

# EUROPEAN SEARCH REPORT

Application Number

EP 16 15 6041

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | J. BURRIEL-VALENCIA ET AL.: "Study of Performance of Several Techniques of Fault Diagnosis for Induction Motors in Steady-State with SVM Learning Algorithms", SECOND INTERNATIONAL CONFERENCE ON ARTIFICIAL INTELLIGENCE, MODELLING AND SIMULATION, 2014, pages 3-8, XP032774635, * page 5, paragraph 6 - page 6, paragraph 1 * * figures 1, 2 * | 1-15 | INV. H02P29/024 |
| X | DIONYSIOS V SPYROPOULOS ET AL: "Induction motor stator fault diagnosis technique using Park vector approach and complex wavelets", ELECTRICAL MACHINES (ICEM), 2012 XXTH INTERNATIONAL CONFERENCE ON, IEEE, 2 September 2012 (2012-09-02), pages 1730-1734, XP032464949, DOI: 10.1109/ICELMACH.2012.6350114 ISBN: 978-1-4673-0143-5 * page 1731, left-hand column * * figures 1, 2 * | 1-15 | |

TECHNICAL FIELDS SEARCHED (IPC)

H02P

The present search report has been drawn up for all claims

| Place of search | Date of completion of the search | Examiner |
|---|---|---|
| Munich | 8 August 2016 | Roider, Anton |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8135551 B
- US 5514978 A
- US 6640196 B
- EP 2565658 A
- GB 1404226 A